# EUROPEAN PATENT APPLICATION

(11) **EP 2 256 820 A2**
(43) Date of publication of application: **01.12.2010**
(21) Application number: 09175048.9
(22) Date of filing: 04.11.2009
(51) Int. Cl.: H01L 31/0224, H01L 31/0352, H01L 31/18, H01L 33/24, H01L 33/08

(54) **Photo-electronic device comprising a vertical p-n or p-i-n junction and manufacturing method thereof**

(30) Priority: 25.05.2009 EP 09160974
(71) Applicant: NXP B.V., 5656 AG Eindhoven (NL)
(72) Inventor: Vanhelmont, Frederik Willem Maurits, Redhill, Surrey RH1 1DL (GB); Furukawa, Yukiko, Redhill, Surrey RH1 1DL (GB); Roozeboom, Freddy, Redhill, Surrey RH1 1DL (GB)
(74) Representative: Williamson, Paul Lewis

(57) **Abstract**

A method is provided for manufacturing a photo-electronic device comprising a vertical p-n or p-i-n junction (22), the junction (22) comprising p-and n-regions. The method comprises the steps of creating the vertical p-n or p-i-n junction (22) with the p- and n-regions disposed laterally over the substrate such that the junction is in a plane perpendicular to the plane of the substrate. The photo-electronic device is formed in a semiconductor water. In another embodiment, the photo-electronic device is formed on a substrate. A roughened surface of an interface between an electrode and the p- or n- region (2,36) and/or a roughened surface of the junction (22) increases the chance of capturing the electrode and hole pairs, gives higher electric field and increased surface of the junction (22).

## Description

### FIELD OF THE INVENTION

The present invention relates to a photo-electronic device comprising a p-n or p-i-n junction and to methods for manufacturing a photo-electronic device comprising a p-n or p-i-n junction.

### BACKGROUND OF THE INVENTION

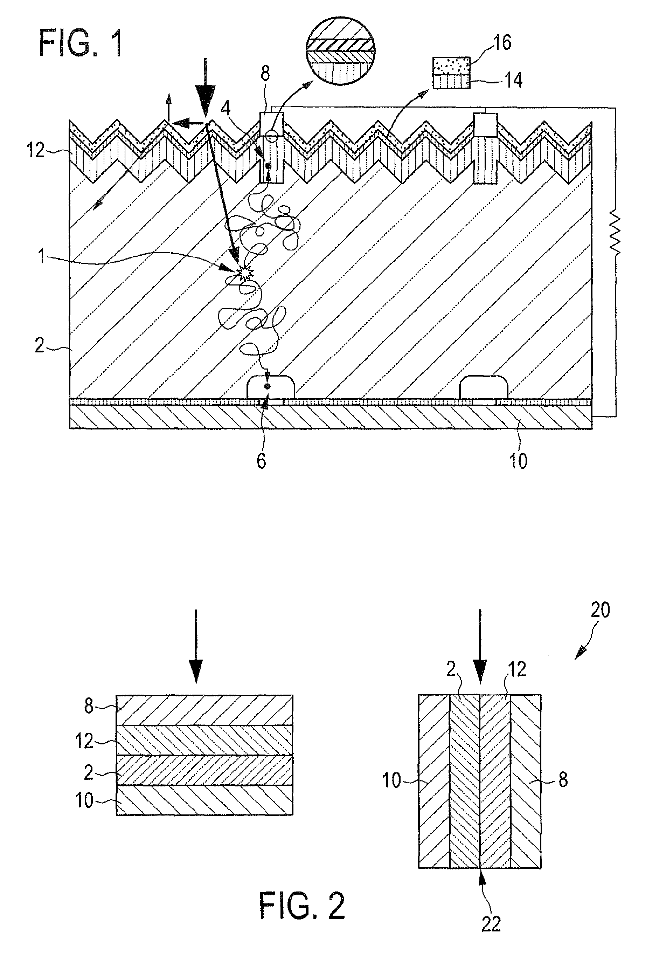

One example of a photo-electronic device comprising a p-n or p-i-n junction is a photovoltaic (PV) cell. A PV cell is a device that converts light energy into electricity by the PV effect. The majority of commercially available photovoltaic cells are silicon (Si) based PV cells with a p-n junction diode. Typically these look as shown in the drawing of Fig. 1 and in the left drawing of Fig. 2.

Light (solar or indoors), as indicated by the large arrow on top of the structure of Fig. 1, is absorbed at location 1 in the volume 2 of Si, thereby creating electron-hole pairs 4, 6 (e- = 4, and h+ = 6); these drift toward the respective electrodes of a titanium-palladium-silver (Ti-Pd-Ag) stack 8 and of aluminum 10 (Al), respectively, due to the internal electrical field and the current can flow. The p-type Si wafer 2 is texturized, diffused with n-type dopant 12, typically phosphorus, to create a p-n junction. On top of the wafer 2 silicon oxide (SiO₂) passivation 14, antireflection coating 16 and screenprinting of electrodes are carried out, followed by co-firing the metal contacts.

It is also known to form p-n junctions by stacking p-type and n-type wafers. Examples of known methods for manufacturing a PV cell are for example disclosed in "Handbook of Photovoltaic Science and Engineering" by A. Luque and S. Hegedus, Wiley, 2002 and "Thin Film Solar Cells" by J. Poortmans and V. Arkhipov, Wiley series in Material for electronic & optoelectronic applications, 2007.

Based on p-n or p-i-n junctions also other photo-electronic devices can be produced, such as photodiodes, photo-sensors, light emitting diodes (LEDs).

### SUMMARY OF THE INVENTION

It is an object of the present invention to provide an improved photo-electronic device comprising a p-n or p-i-n junction and to provide an improved method for manufacturing a photo-electronic device comprising a p-n or p-i-n junction.

According to the invention, there is provided a method for manufacturing a photo-electronic device comprising a p-n or p-i-n junction, the junction comprising p- and n-regions, the method comprising:
- etching to provide a hole, pore or trench into a semiconductor wafer;
- depositing a cover layer for covering the hole pore or trench;
- depositing a metal seed layer;
- opening a blind hole in the wafer from the wafer backside;
- depositing a metal layer into the hole;
- patterning the metal seed layer; and
- creating the vertical p-n or p-i-n junction using the patterned seed layer, such that the p-n or p-i-n junction is created with the p- and n-regions disposed laterally over the substrate such that the junction is in a plane perpendicular to the plane of the substrate.

The invention thus provides a vertically oriented junction rather than a horizontally oriented junction.

Preferably, the method comprises the following steps:
- providing the first-type semiconductor wafer with a dielectric or passivation layer on top;
- etching the dielectric or passivation layer locally;
- performing the etching to provide the hole, pore or trench into the wafer;
- removing the cover layer after opening the blind hole;
- wherein patterning the metal seed layer further comprises patterning the dielectric or passivation layer.

Etching the wafer can comprise using the Bosch process and can comprise forming roughened edge surfaces to the hole, pore or trench. This gives improved photo conversion efficiency. The roughened surfaces can be formed by Hemispherical Si Growth (HSG) or by sequential isotropic etching and anisotropic etching to form small diameter portions and large diameter portions.

Creating the vertical p-n or p-i-n junction can be carried out by one of the following methods:
by implanting second-type dopant followed by an activation step;
by diffusion of second-type dopant followed by an activation step; or
by etching a trench and subsequently depositing second-type semiconductor in the trench.

If the vertical junction is created by etching a trench and subsequently depositing second-type semiconductor in the trench, an extra oxidation step can be provided before depositing the second-type semiconductor to make a vertical p-i-n junction.

According to a second aspect of the invention, there is provided a method for manufacturing a photo-electronic device comprising a p-n or p-i-n junction, the junction comprising p- and n-regions, the method comprising:
- providing a substrate comprising a seed layer for metal plating;
- applying a photoresist layer and providing it with a patterned mask;
- providing a first hole or trench in the photoresist layer;
- depositing metal to fill the first hole or trench;
- removing photoresist to provide a second hole or trench in the photoresist layer;
- depositing a first-type semiconductor in the second hole or trench; and
- depositing a second-type semiconductor,
wherein the p-n or p-i-n junction is created with the p- and n-regions disposed laterally over the substrate such that the junction is in a plane perpendicular to the plane of the substrate.

The method can further comprise patterning the seed layer by photolithography, and wherein the mask for the photoresist layer is based on the inverse with respect to the mask applied for the patterning of the seed layer.

In one example removing photoresist only partially removes the photoresist layer and the method further comprises:
- after depositing the first-type semiconductor, removing the remaining photoresist layer to provide a trench; and
- depositing a second-type semiconductor to fill the trench.

In another example removing photoresist fully removes the photoresist layer and the method further comprises:
- after depositing the first-type semiconductor, etching the first-type semiconductor to provide a trench; and
- depositing a second-type semiconductor to fill the trench.

In another example removing photoresist fully removes the photoresist layer and wherein depositing a first-type semiconductor in the second hole comprises depositing a film of the first-type semiconductor, a film of the second-type semiconductor and an electrode layer.

In all examples:
the method can further comprise depositing a passivation layer and/or an anti-reflective coating after forming the p-n or p-i-n junction; and/or
an extra oxidation step can be applied before depositing the second type of can be included to form a vertical p-i-n junction; and /or
providing the first and/or second hole pore or trench in the photoresist layer can again comprise forming roughened edge surfaces to the hole e.g. by HSG deposition or sequential isotropic and anisotropic etching.

The invention also provides a photo-electronic device comprising a p-n or p-i-n junction, the junction comprising p- and n-regions, wherein the p- and n-regions are disposed laterally over the substrate such that the junction is in a plane perpendicular to the plane of the substrate.

The device comprises a first interface surface between a first electrode and one of the p- and n-regions and a second interface surface between a second electrode and the other of the p- and n-regions, wherein one or more of the first interface, the second interface and the junction comprises a roughened surface for increasing the surface area by a factor of at least 1.5 compared to a planar surface.

The present invention is based on the realisation that the known photo-electronic devices comprising a p-n or p-i-n junction, such as PV cells have certain disadvantages. First of all, the semiconductor (such as Si) does not absorb the solar light very efficiently. Therefore, the thickness of the Si layers in the cell needs to be increased to improve the efficiency. However, this makes the distance towards the electrodes longer and therefore the chance of recombination of the electron-hole pair increases as well. Therefore, there is a trade-off between the absorption of the light when using thick layers and the recombination of the carriers when using thin layers. In this way the energy conversion efficiency for a multicrystalline prior art PV cell is only 14-16 %.

Embodiments of the present invention use a PV with vertically deposited p-n or p-i-n junctions, i.e., a PV cell in which the p-type semiconductor layer and the n- type semiconductor layer are not placed vertically on top of each other, but the entire electrode-p-n-electrode stack is rotated by about 90 degrees, so that the p-n or p-i-n junctions are vertical so that the direction of the light to be absorbed is substantially parallel to the p-n or p-i-n junctions.

In embodiments of the present invention the thickness of the main semiconductor layer can be increased so that there is more efficient sunlight absorption without increasing the distance to the electrodes. In this way the photovoltaic cell can be more efficient.

In particular the present invention is based on the realisation that it is much more elegant in processing when depositing the respective layers of the photo-electronic device comprising a vertical p-n or p-i-n junction next to each other during manufacturing than stacking of p-doped and n-doped thinned wafers for manufacturing the p-n junctions as previously disclosed. Furthermore the processing according to the invention is compatible with standard IC processing. Therefore the photo-electronic devices of embodiments of the present invention can be integrated together with other IC devices.

Embodiments of the invention provide a high flexibility in choice of materials (electrodes, dielectric and semiconductor material) and processing.

Furthermore, the electrodes of embodiments of the present invention can be made from a better conductive electrode, e.g. by using Cu, as compared to the electrode of a conventional photo-electronic device, e.g. a PV cell. The reference to first-type and second-type semiconductor (in the claims) refers to n-type and p-type. The "first-type" is n- or p-type and the "second-type" is then p- or n-type respectively, i.e. the first and second types are opposite but both possible combinations are possible.

The use of roughened surfaces as outlined above increases the chance of capturing the electrode and hole pairs, gives higher electric field and increased surface of the p-n junction.

Also, the electrodes and/or barrier layers of embodiments of the present invention can be highly reflective so that they can act as a mirror and the light can be trapped more easily into the absorbing layers. Additionally, in embodiments of the present invention an anti-reflective coating can be applied so that light can be trapped efficiently.

### BRIEF DESCRIPTION OF THE DRAWINGS

These and other aspects of the invention will be apparent from and elucidated with reference to the embodiments described hereinafter. In the following drawings
Fig. 1 shows a schematic illustration of a PV cell according to the prior art and as described above;
Fig. 2 shows on the right hand side the general principle of a photo-electronic device comprising a vertical p-n or p-i-n junction according to the present invention compared to the prior art shown on the left side;
Fig. 3-6 show schematic illustrations of embodiments according to the present invention, in particular methods for manufacturing a photo-electronic device comprising a vertical p-n or p-i-n junction, the device being in the form of a PV cell;
Fig. 7 shows how roughened side walls can be formed by sequential isotropic and anisotropic etching to form small diameter portions and large diameter portions;
Fig. 8 is an image showing roughened side walls created by the method explained with reference to Fig. 7; and
Fig. 9 is an image showing roughened side walls created by another method involving HSG deposition.

### DETAILED DESCRIPTION

The present invention is further elucidated by the figures and examples, which are not intended to limit the scope of the invention. The person skilled in the art will understand that various embodiments may be combined.

Fig. 2 shows on the right hand side the general principle of PV cells as a photo-electronic device comprising a vertical p-n or p-i-n junction of the present invention. It shows a PV cell 20 with a vertical p-n junction 22 manufactured by depositing the respective layers 8, 12, 2, 10 of the PV cell 20 next to each other on a substrate (not shown).

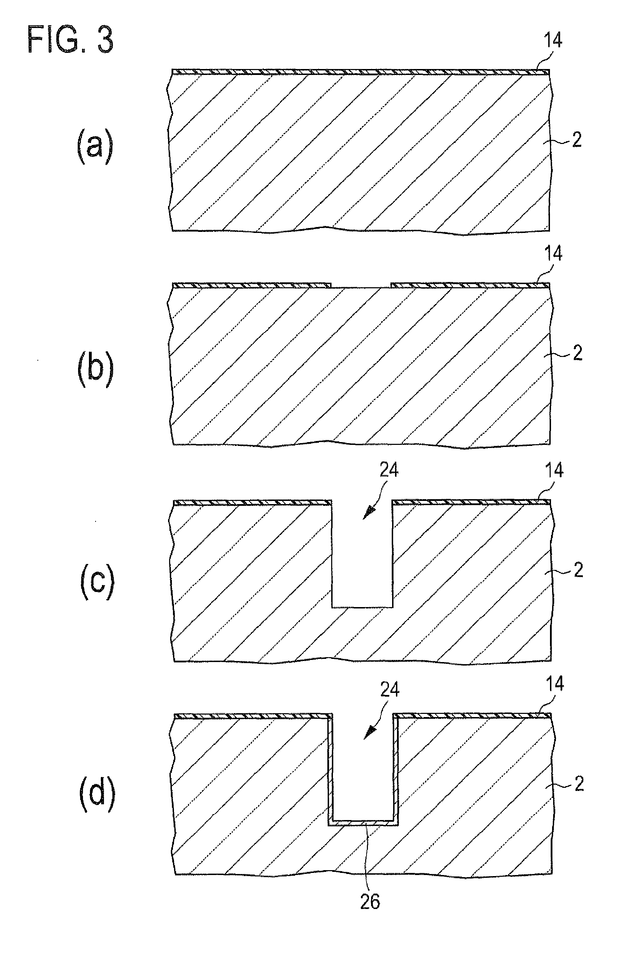

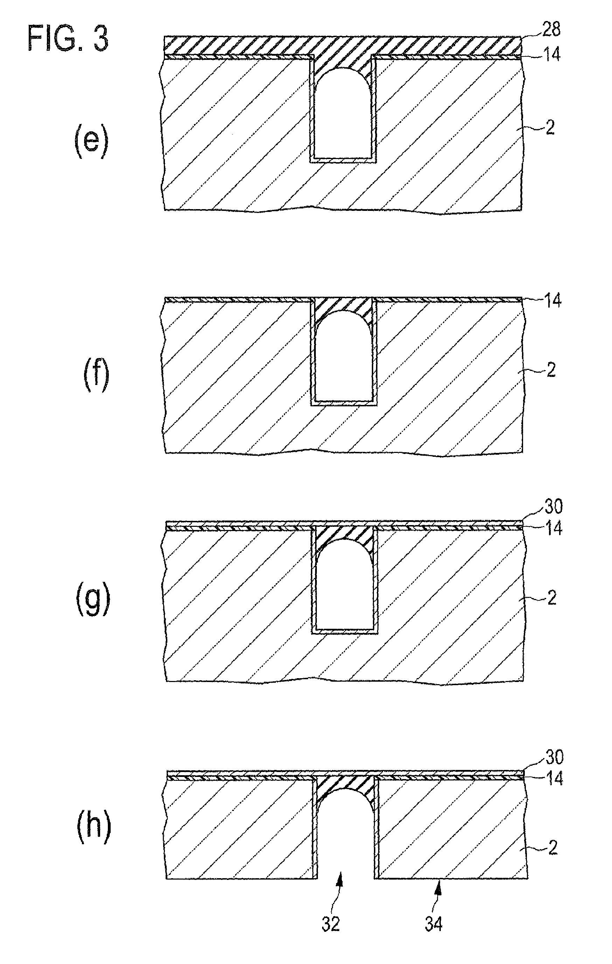

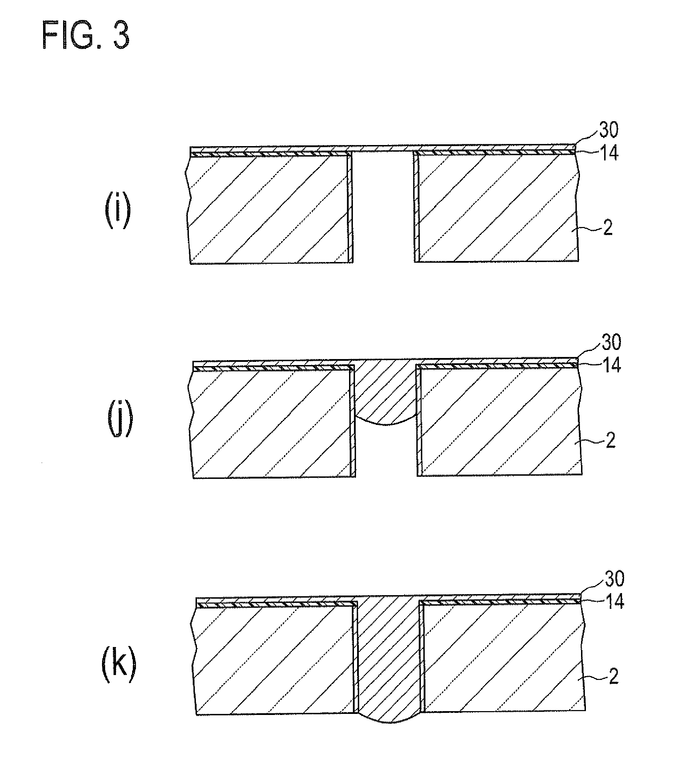

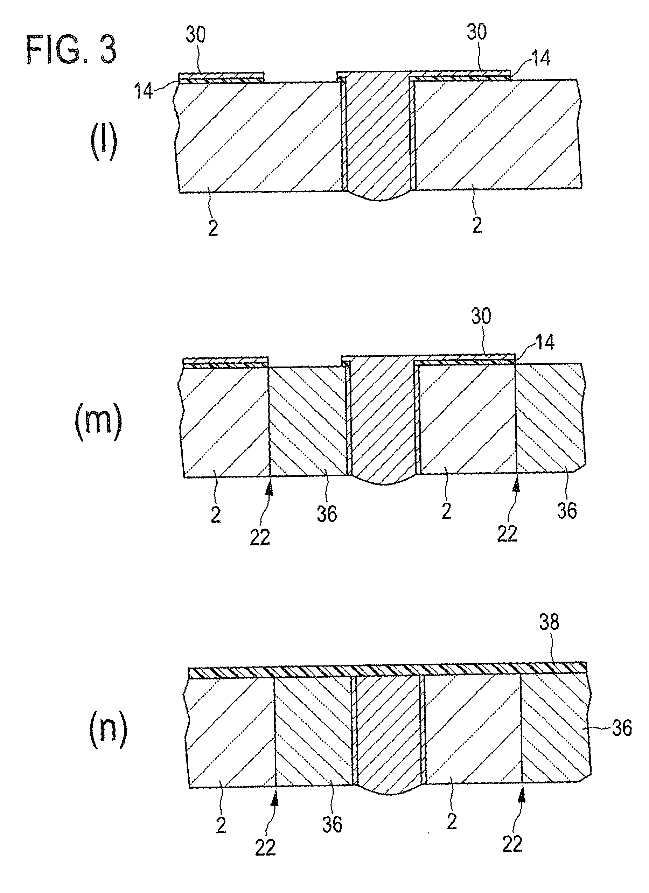

Fig. 3 shows as an embodiment of the present invention a method for manufacturing a Si p-n PV cell 20 as a photo-electronic device comprising a vertical p-n junction 22, which method comprises the following steps which are partly indicated in Fig. 3 by the respective references (a)-(n) used in the following:
providing a p-type Si wafer 2 with a dielectric SiO₂ passivation layer 14 on top, (a)
etching the passivation layer 14 locally, (b)
etching, preferably by a reactive ion etch, to provide a deep hole 24, pore or trench into the wafer 2, for example by the so-called Bosch process, (c)
depositing a Cu-diffusion barrier layer 26, for example TiN, TaN, TiW, and the like. This layer 26 will also cover the passivation layer 14 although this is not shown in order to keep the drawings simple, (d)
depositing a cover layer 28 of PMMA, preferably by spin coating and subsequent curing, for covering the hole 24, (e)
back-polishing this layer 28, preferably by Chemical Mechanical Polishing (CMP), (f)
depositing a Cu seed layer 30, preferably by PVD; preferably this deposition is preceded by depositing a Ti adhesion layer, (g)
opening the blind hole 32 in the wafer 2 from the wafer backside 34 by grinding; preferably polishing and etching is performed to remove damage optionally induced by the grinding, (h)
removing the PMMA by heating at higher temperatures, (i)
electroplating Cu, (j and k)
preferably steps (a) through (k) are performed as described in the international publication WO/2007/054867,
patterning the Cu seed layer 30, the Cu-diffusion barrier layer 26 and the passivation layer 14 by lithography and etching, (I)
creating the vertical p-n junction 22, by implanting n-dopant 36 followed by an activation step, or by diffusion of n-dopant 36 from e.g. POCl₃ and followed by an activation step, or by etching an extra deep trench and subsequently depositing of a n-type Si to fill the trench and removing of the n-type Si on top of the electrode and the p-type Si,
preferably the Si can be deposited by e.g. RF-PECVD at about 200-250 °C, because such a process will cause negligible or no damage to any CMOS device that is possibly present on the same wafer 2, (m)
applying a passivation layer 38 and/or an anti-reflective coating,(n)

It is also possible to start with an n-type Si wafer and create the p-type Si regions by deposition / implantation / diffusion.

It is also possible to make a vertical p-i-n junction when using the trench etch method above. Before depositing the n-type Si an extra oxidation step can preferably be included.

The afore-mentioned embodiment is not limited to Si and can also be used with other single crystalline semiconductor materials like SiGe, SiGeC, etc.

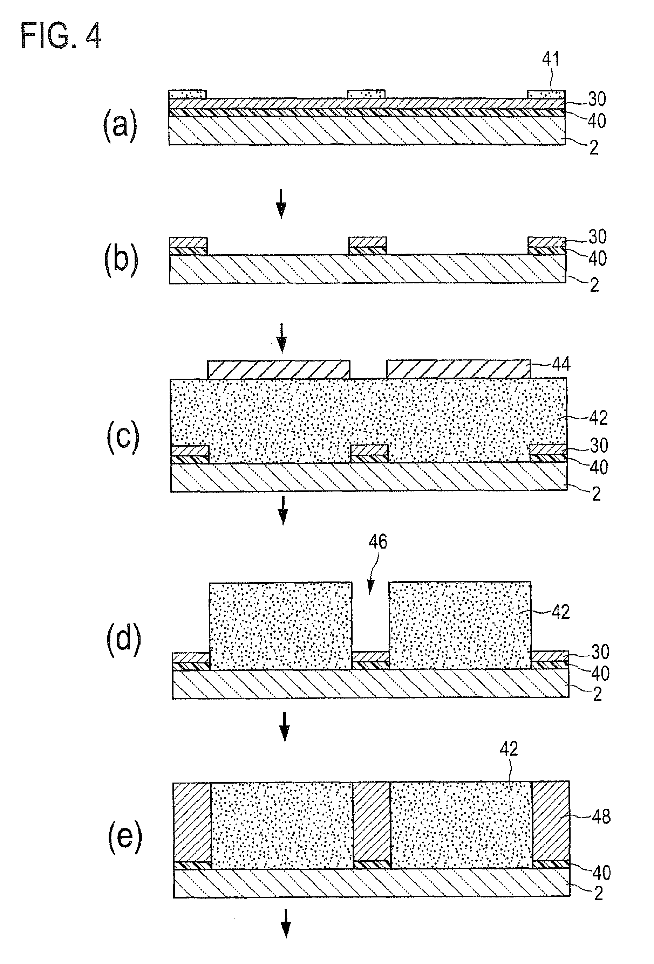

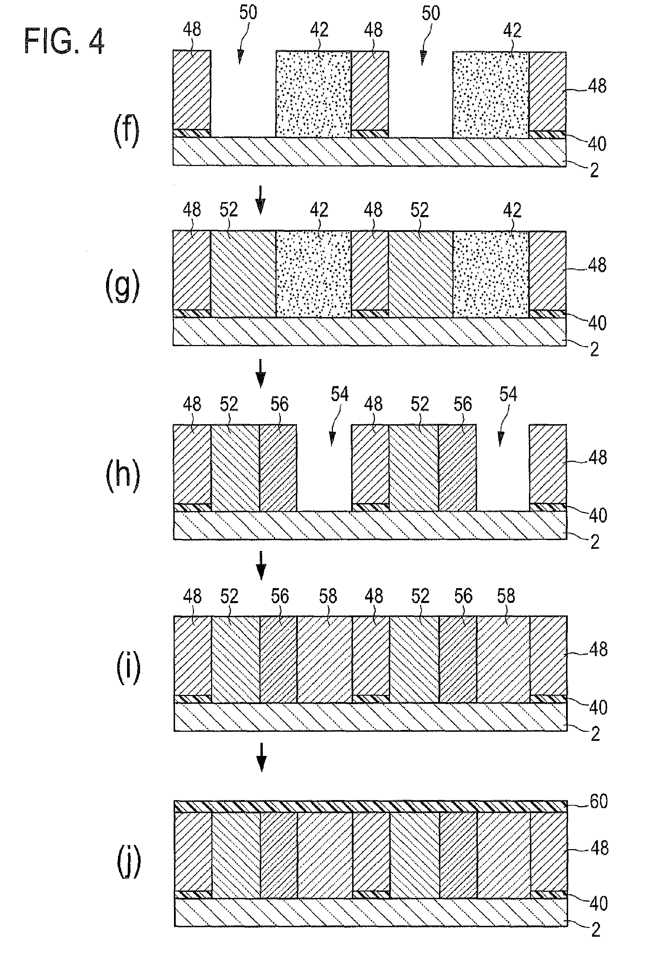

Fig. 4 shows as an embodiment of the present invention again for manufacturing a thin film PV cell 20, such as a Si p-n or p-i-n PV cell 20, as a photo-electronic device comprising a vertical p-n or p-i-n junction 22, which method comprises the following steps which are partly indicated in Fig. 4 by the respective references (a)-(j) used in the following:
providing a Si or glass or organic substrate containing an adhesion layer 40 and a seed layer 30 for Cu plating, (a)
patterning these layers 40, 30 by photolithography with a first mask 41, (b)
applying a thick photoresist (PR) layer 42 and providing it with a patterned mask 44 that is inversely patterned or very similar to the inverse mask with respect to the mask 41 applied in the first patterning, (c)
etching and resist stripping to provide holes or trenches 46 in the thick PR layer 42, (d)
plating Cu 48 to fill the holes or trenches 46, (e)
partially removing the PR to provide holes or trenches 50 in the thick PR layer 42, (f)
depositing p-type Si 52 to fill the holes or trenches 50, e.g. by performing a thin film deposition of in situ doped silicon, e.g. by CVD using a Si source such as SiH₄ or SiH₂Cl₂, SiHCl₃ with a B source such as BH₃ or B₂H₆ gas mixture, and removing the deposited p-type Si 52 on top of the Cu 48 and on top of the thick PR layer 42, (g)
removing the thick PR layer 42 to provide holes or trenches 54 and - if a p-i-n junction is desired - partially oxidizing the p-type Si 52 being one side wall 56 of the holes or trenches 54, (h)
depositing n-type Si 58 to fill the trenches 54, e.g. by performing thin film deposition of in situ doped silicon from a by CVD using a Si source such as SiH₄ or SiH₂Cl₂, SiHCl₃ with a P source such as PH₃ gas mixture, and removing the deposited n-type Si 58 on top of the Cu 48 and on top of p-type Si 52 and on top of the oxidized Si 56, (i)
depositing a passivation layer 60, (j)

Alternatively, the PR can be removed completely, then p-type Si 52 can be deposited, the excess p-type Si on the electrode is removed, p-type Si 52 can be deep etched like in the previous method, and the p-type Si 52 can optionally be partially oxidized. The pore is then filled with n-type Si 58 and the excess of n-type Si 58 on the electrodes and p-type Si 52 is removed.

The deposition of p-type Si 52 and n-type Si 58 can also be reversed. Also different semiconductor compound materials such as copper indium gallium selenide (CIGS) or CdTe or organic or polymer semiconductors can be deposited instead of the Si base semiconductor.

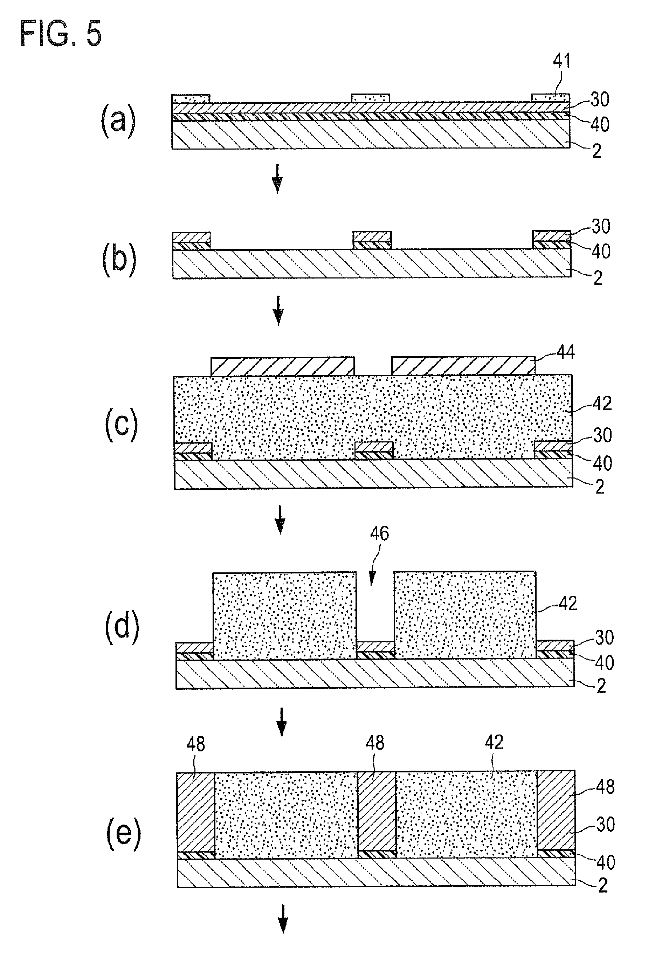

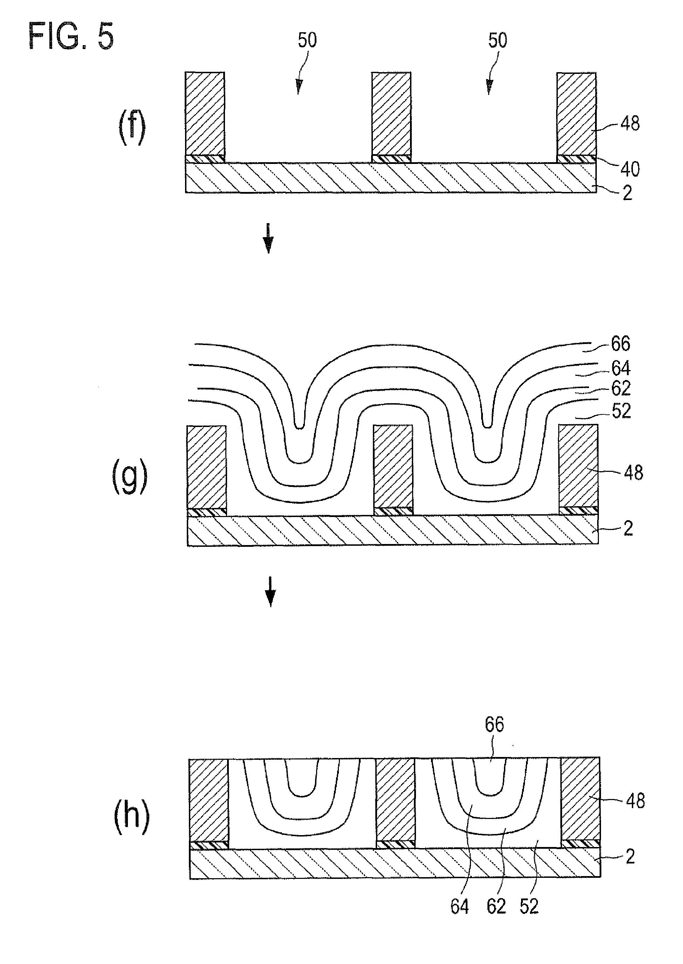

Fig. 5 shows as an embodiment of the present invention again for manufacturing a thin film photovoltaic cell, such as a Si p-n or p-i-n PV cell 20, as a photo-electronic device comprising a vertical p-n or p-i-n junction 22, which method comprises the following steps which are partly indicated in Fig. 5 by the respective references (a)-(h) used in the following:
providing a Si or glass or organic substrate containing an adhesion layer 40 and a seed layer 30 for Cu plating, (a)
patterning these layers by photolithography with a first mask 41, (b)
applying a thick PR layer 42 and providing it with a patterned mask 44 that is inversely patterned or very similar to the inverse mask with respect to the mask 41 applied in the first patterning, (c)
etching and resist stripping to provide holes or trenches 46 in the thick PR layer 42, (d)
plating Cu 48 to fill the holes or trenches 46, (e)
removing the PR to provide holes or trenches 50 between the metal electrodes 48, (f)
depositing a thin film of p-type Si 52, optionally depositing TEOS 62 as an insulator like or oxidizing p-type Si 52, depositing a thin film of n-type Si 64 and depositing an electrode layer 66, (g)
preferably performing a CMP step, (h)
applying a passivation layer 60 and/or an anti-reflective coating on top (not shown in Fig. 5 but similar to Fig. 4(j)).

Also different semiconductive materials such as CIGS, CdTe, organic and polymer semiconductors etc., can be deposited instead of the Si base semiconductor.

Here again the deposition of the p-type Si 52 and n-type Si 58 can be reversed.

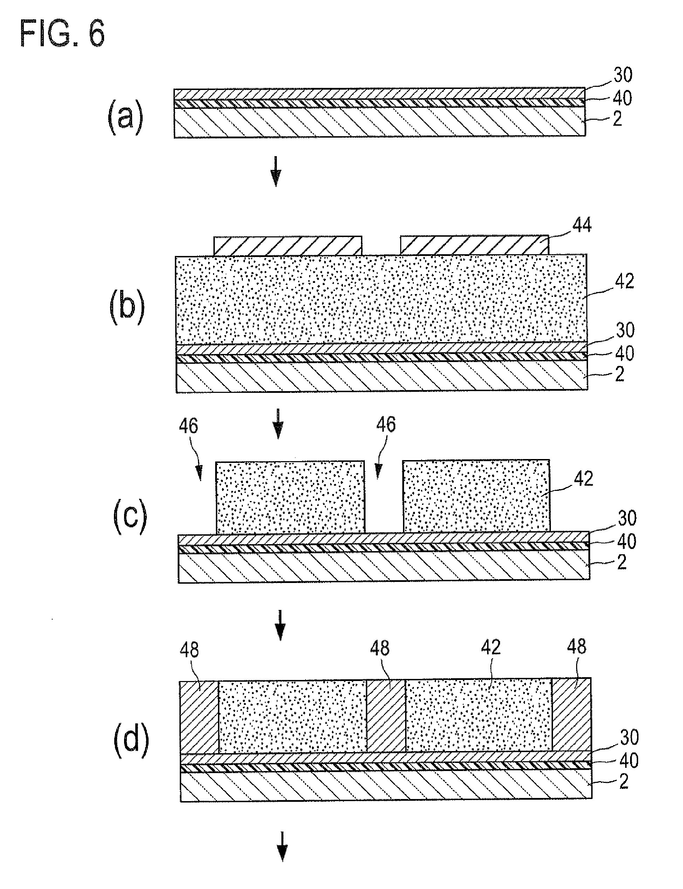

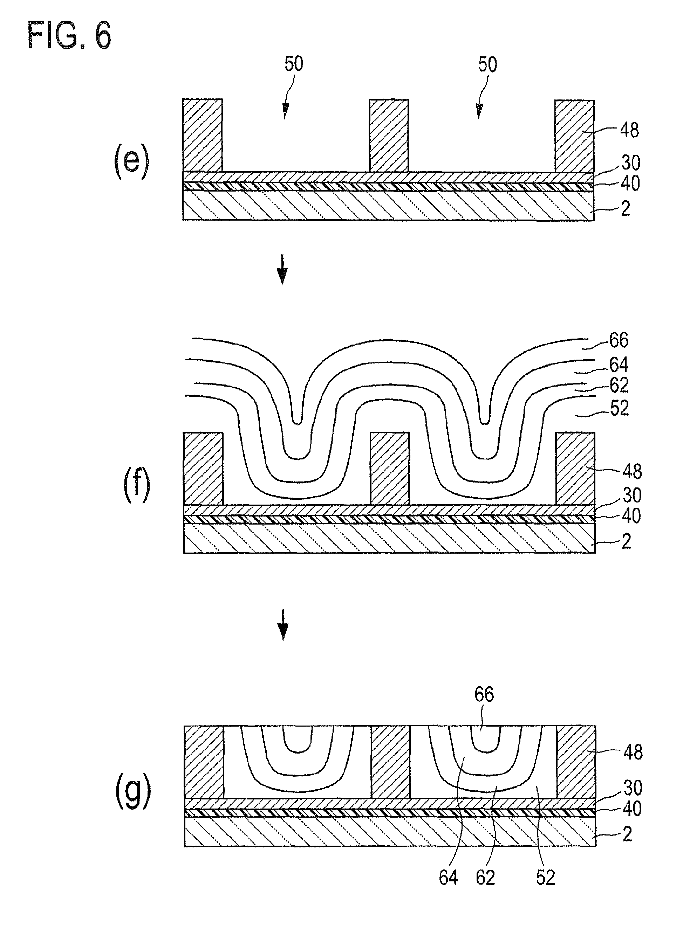

Fig. 6 shows as an alternative embodiment for the embodiment of Fig. 5 comprising the same steps but the initial Cu plating seed layer 30 is not patterned.

For all shown embodiments of the present invention the lateral dimensions depend on the lithography node or e-beam dimensions and the reactive ion etch and deposition technology, like Atomic Layer Deposition and ionized PVD for high aspect ratio sputtering. For example state-of-the-art DRAM production can produce 32 nm wide structures with an aspect ratio of 60. It is not impossible that this will improve over time.

The methods above provide a highly efficient photovoltaic cell (photo-electronic device) by turning the p-n or p-i-n junction 90 degrees.

A further measure can be taken to improve the process, by increasing the surface area of the sidewalls of the electrodes and/or the semiconductor.

This increases the chance that a created electron-hole pair is *captured* by the electrodes. Furthermore, the area where the p-n or p-i-n junction is located increases, so that the chance of *creating* an electron-hole pair is also increased.

In addition, due to rough electrodes, the electric field can be locally much higher and therefore the depletion region can be increased as well; this is again beneficial for the capturing of the electrons and holes. This enables further improvement to efficiency.

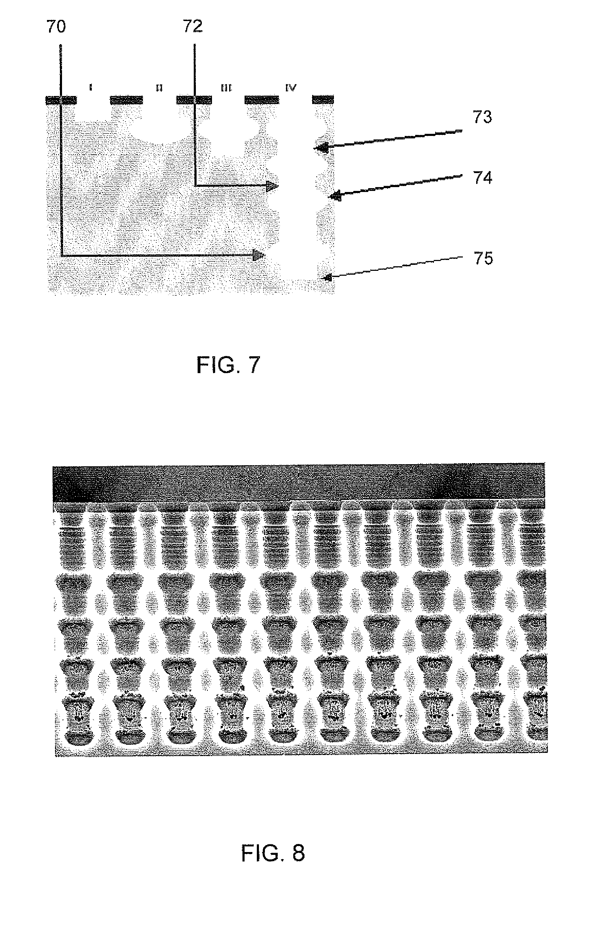

The surface area can be increased by using an intentional non-optimized Bosch-process for etching the trenches. Normally, the etching is optimised to obtain straight side-walls as shown above. However, scallops can be intentionally created as shown in Figure 7.

This can be done by increasing the isotropic/anisotropic etching ratio or by alternating between a more isotropic and a more anisotropic etch recipe.

Figure 7 shows the effect of isotropic etching 70 and anisotropic etching 72, resulting in small diameter portions 73 and large diameter portions 74 of the trench in the silicon (or other semiconductor) substrate 75.

A result of such a process is shown in Figure 8 from a scanning electron microscope.

Alternatively or additionally, Hemispherical Si Growth (HSG) can be used for the Si that needs to fill the trenches. This deposition method yields very monodisperse islands of Si. These islands can be tuned in sizes ranging from an average of 20 nm up to 200 nm, depending on the CVD process conditions. The HSG method increases the surface area by a factor of 2.1-2.5 times, and has been commercially used in sub-micron DRAM technology nodes down to 65 nm.

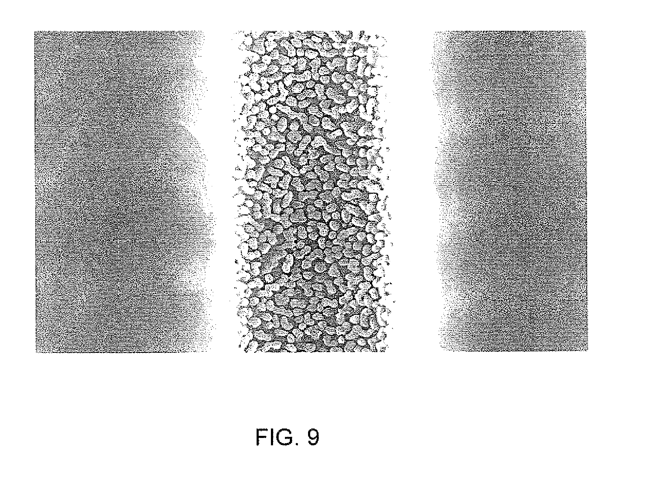

A result of such a process is shown in Figure 9 from a scanning electron microscope. This process has for example been used in capacitor applications to double the surface area of a trench capacitor bottom (silicon) electrode, as an alternative to thinner oxide/nitride insulator films or the development of higher dielectric constant insulators.

In this application, the roughening can be applied to the electrodes and the semiconductor of the vertical device.

The roughening in the HSG process is believed to be caused by the high mobility of Si atoms during deposition on a clean Si surface, leading to a *hemispherical grain* surface structure. Originally, conventional low pressure chemical vapor deposition (LPCVD) SiH processes at approximately 130 Pa (1 Torr) and 30 Pa (0.2 Torr) were reported to yield effective area enhancements of 2.1-2.5 times, as determined from measurements of capacitors formed on the rough Si surfaces.

Direct CVD growth has subsequently been reported by Dana *et al.* (S.S. Dana M. Anderle, G.W. Rubloff and A. Acovic, Appl. Phys. Lett. 63 (1993) 1387) enabling deposition of rough Si films over a much broader temperature range (> 100 °C) carried out by SiH growth (undiluted) on SiO₂ surfaces at relatively low temperatures (600 °C) and at low pressures such as few tenths of a Pa (mTorr).

Under these conditions the broad temperature window for rough Si film morphology is achieved through the combination of nucleation controlled initial growth (on SiO₂) and domination of growth by surface reaction.

More recently, the capacitance enhancement of deep submicron DRAM trench capacitors has been reported with Al₂O₃ ALD dielectric layers deposited on HSG bottom electrode layers.

The roughened surfaces can define the p-n junction or the electrode surfaces, or any combination of these. In the case of a p-i-n junction, the roughened surfaces can be at the p-i boundary or the i-n boundary and/or at the electrode surfaces. Of course, once one surface has been roughened, deposition of an adjacent layer will provide a roughened interface.

The invention also provides the vertical junction device. When roughening is used, the surface area preferably increases by a factor of at least 1.5 compared to a planar surface, and more preferably by a factor of more than 2. The device has a first interface surface between a first electrode and one of the p- and n-regions and a second interface surface between a second electrode and the other of the p- and n-regions. The roughening can be applied to the first interface, the second interface and/or the junction.

The electrodes can be placed in such a way that they can form a connection towards another die and maybe power it as well. Using such electrodes, the PV cell 20 can in this way be connected to other dies in one SiP package.

These concepts can also be used for creating a photodiode or photosensor or a LED.

In the present application, copper (Cu) is given as example of metal used. However, it is only an example for a metal and/or conductive material, only, and any other metal and/or conductive material can be used instead of Cu. In such a case a suitable barrier material is preferably used.

For all embodiments of the present invention the lateral dimensions depend on the lithography node or e-beam dimensions and the reactive ion etch and deposition technology, like Atomic Layer Deposition and ionized PVD for high aspect ratio sputtering. For example state-of-the-art DRAM production can produce 32 nm wide structures with an aspect ratio of 60. It is not impossible that this will improve over time.

Some alternatives to the processes described have been mentioned above. In particular, the detailed examples above start with a p-type substrate, but it also possible to start with an n-type semiconductor wafer and create p-type regions by deposition, implantation or diffusion. In all examples, it is possible to make a vertical p-i-n junction when using the trench etch method above. Before depositing the second-type semiconductor an extra oxidation step can preferably be included. The patterning of the initial Cu plating layer in the examples above is not essential.

In the embodiments of the present invention and in the claims the word "comprising" does not exclude other elements or steps, and the indefinite article "a" or "an" does not exclude a plurality. A single device, element or other unit may fulfill the functions of several items recited in the claims. The mere fact that certain measures are recited in mutually different dependent claims does not indicate that a combination of these measured cannot be used to advantage.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim.

## Claims

1. A method for manufacturing a photo-electronic device comprising a p-n or p-i-n junction (22), the junction (22) comprising p- and n-regions, the method comprising:
- etching to provide a hole (24), pore or trench into a semiconductor wafer (2);
- depositing a cover layer (28) for covering the hole (24) pore or trench;
- depositing a metal seed layer (30);
- opening a blind hole (32) in the wafer (2) from the wafer backside (34);
- depositing a metal layer into the hole (32);
- patterning the metal seed layer (30); and
- creating the vertical p-n or p-i-n junction (22) using the patterned metal seed layer, such that the p-n or p-i-n junction (22) is created with the p- and n-regions disposed laterally over the substrate such that the junction is in a plane perpendicular to the plane of the substrate.

2. A method as claimed in claim 1, comprising the following steps:
- providing the first-type semiconductor (52) wafer (2) with a dielectric or passivation layer (14) on top;
- etching the dielectric or passivation layer (14) locally;
- performing the etching to provide the hole (24), pore or trench into the wafer (2);
- removing the cover layer (28) after opening the blind hole;
- wherein patterning the metal seed layer (30) further comprises patterning the dielectric or passivation layer (14).

3. A method as claimed in claim 2, wherein etching the wafer comprises using the Bosch process.

4. A method as claimed in claim 2 or 3, wherein etching the wafer comprises forming roughened edge surfaces to the hole, pore or trench.

5. A method as claimed in any one of claims 2 to 4, wherein creating the vertical p-n or p-i-n junction (22) is carried out by one of the following methods:
- by implanting second-type dopant (36) followed by an activation step;
- by diffusion of second-type dopant (36) followed by an activation step; or
- by etching a trench and subsequently depositing second-type semiconductor in the trench.

6. The method according to claim 5, wherein creating the vertical p-n or pi-n junction (22) is carried out by etching a trench and subsequently depositing second-type semiconductor in the trench, and wherein an extra oxidation step is provided before depositing the second-type semiconductor (58) to make a vertical p-i-n junction (22).

7. A method for manufacturing a photo-electronic device comprising a p-n or p-i-n junction (22), the junction (22) comprising p- and n-regions, the method comprising:
- providing a substrate comprising a seed layer (30) for metal plating;
- applying a photoresist layer (42) and providing it with a patterned mask (44);
- providing a first hole or trench (46) in the photoresist layer (42);
- depositing metal (48) to fill the first hole or trench (46);
- removing photoresist to provide a second hole or trench (50) in the photoresist layer (42);
- depositing a first-type semiconductor (52) in the second hole or trench (50); and
- depositing a second-type semiconductor (58),
wherein the p-n or p-i-n junction (22) is created with the p- and n-regions disposed laterally over the substrate such that the junction is in a plane perpendicular to the plane of the substrate.

8. A method as claimed in claim 7, further comprising patterning the seed layer by photolithography, and wherein the mask for the photoresist layer (42) is based on the inverse with respect to the mask applied for the patterning of the seed layer.

9. A method as claimed in claim 7 or 8, wherein
(i) removing photoresist only partially removes the photoresist layer and the method further comprises:
- after depositing the first-type semiconductor (52), removing the remaining photoresist layer to provide a trench (54);
- depositing a second-type semiconductor (58) to fill the trench (54), or
(ii) removing photoresist fully removes the photoresist layer and the method further comprises:
- after depositing the first-type semiconductor (52), etching the first-type semiconductor to provide a trench (54);
- depositing a second-type semiconductor (58) to fill the trench (54), or
(iii) removing photoresist fully removes the photoresist layer and wherein depositing a first-type semiconductor (52) in the second hole or trench (50) comprises depositing a film of the first-type semiconductor, a film of the second-type semiconductor and an electrode layer.

10. A method as claimed in any preceding claim wherein the method further comprises depositing a passivation layer (38) and/or an anti-reflective coating after forming the p-n or p-i-n junction.

11. A method as claimed in any one of claims claim 7 to 10, wherein providing the first (46) and/or second (50) hole or trench in the photoresist layer comprises forming roughened edge surfaces to the hole.

12. A method as claimed in claim 4 or 11, wherein the roughened surfaces are formed by Hemispherical Si Growth (HSG) or by sequential isotropic etching (70) and anisotropic etching (72) to form in small diameter portions (73) and large diameter portions (74).

13. The method according to any preceding claim, wherein the semiconductor comprises CIGS, CdTe, organic and polymer semiconductors, Si, SiGe or SiGeC.

14. The method according to any preceding claim, further comprising placing electrodes such as to form power connection means for connection to an adjacent die.

15. A photo-electronic device comprising a p-n or p-i-n junction (22), the junction (22) comprising p- and n-regions, wherein the p- and n-regions are disposed laterally over the substrate such that the junction is in a plane perpendicular to the plane of the substrate, wherein the device comprises a first interface surface between a first electrode and one of the p- and n-regions and a second interface surface between a second electrode and the other of the p- and n-regions, wherein one or more of the first interface, the second interface and the junction comprises a roughened surface for increasing the surface area by a factor of at least 1.5 compared to a planar surface.
